(19) Europäisches Patentamt / European Patent Office / Office européen des brevets

(11) **EP 2 451 063 A1**

(12) **EUROPEAN PATENT APPLICATION**
published in accordance with Art. 153(4) EPC

(43) Date of publication:
**09.05.2012 Bulletin 2012/19**

(51) Int Cl.:
*H02M 3/155* (2006.01)  *H01L 25/07* (2006.01)
*H01L 25/18* (2006.01)

(21) Application number: **09846793.9**

(22) Date of filing: **30.06.2009**

(86) International application number:
**PCT/JP2009/061899**

(87) International publication number:
**WO 2011/001500 (06.01.2011 Gazette 2011/01)**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(71) Applicant: **Fujitsu Limited**
**Kawasaki-shi, Kanagawa 211-8588 (JP)**

(72) Inventors:
• **YONEZAWA, Yu**
**Kawasaki-shi**
**Kanagawa 211-8588 (JP)**

• **DEGUCHI, Hideaki**
**Kawasaki-shi**
**Kanagawa 211-8588 (JP)**
• **NAKASHIMA, Yoshiyasu**
**Kawasaki-shi**
**Kanagawa 211-8588 (JP)**

(74) Representative: **HOFFMANN EITLE**
**Patent- und Rechtsanwälte**
**Arabellastraße 4**
**81925 München (DE)**

(54) **DC-DC CONVERTER, MODULE, POWER SUPPLY DEVICE AND ELECTRONIC APPARATUS**

(57)     A controller CT1 switches on a first switch SW1, and the direct-current voltage given from a power source BAT flowing through a first inductor L1 is smoothed by a capacitor C1 and is output from an output terminal OUT1. After a specified period of time has elapsed since the first switch SW1 was turned off by the controller CT1, the second switch SW2 and the third switch SW3 are turned on approximately at the same time. The electric current which was flowing through the first inductor L1 is branched into the second switch SW2 and the third switch SW3, and the electric current flowing through the parasitic diode Dp1 of the second switch SW2 is reduced. As a result, when the second switch SW2 is turned off, the recovery current flowing through the parasitic diode Dp1 is reduced.

FIG. 2

## Description

FIELD

The embodiment described herein relates to a DC-DC converter, a module, a power supply device, and an electronic apparatus, in each of which the loss is small.

BACKGROUND

Switching power sources in which the conversion loss is small and whose downsizing is easily achieved are used in various fields including the field of an electronic apparatus such as computers. The switching power sources are configured to convert the input direct-current voltage into a desired direct-current voltage by using a DC-DC converter, and to output the converted direct-current voltage as a stabilized power source voltage. The switching power sources capable of outputting a low voltage and a large electric current have been used for a semiconductor device of a CPU (Central Processing Unit) in a computer as the voltage is lowered and the power consumption increases. For this reason, a synchronously rectifying buck converter in which the loss is small when a large amount of electric current is output is sometimes used as a DC-DC converter.

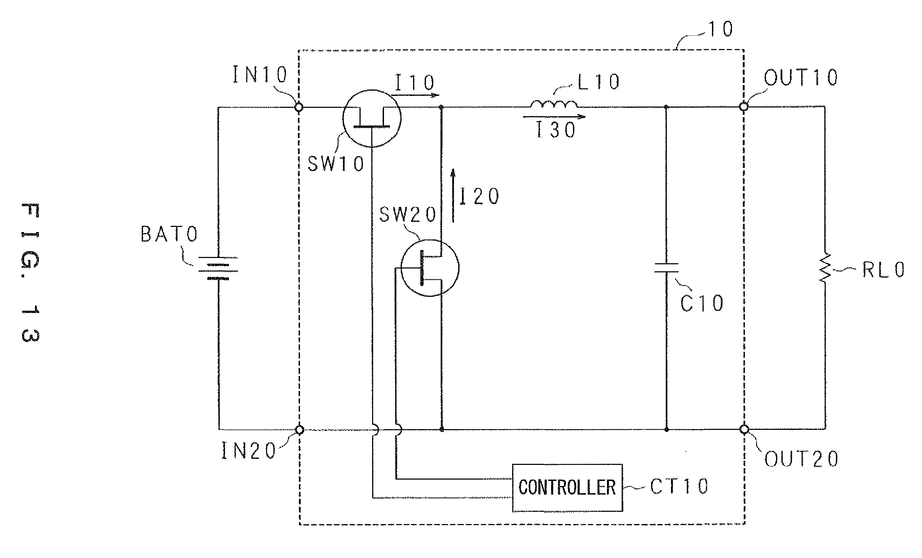

FIG. 13 is a schematic circuit diagram illustrating a conventional DC-DC converter. A DC-DC converter 10 as a synchronously rectifying buck converter includes a first switch SW10 as a main switch which turns on and off a DC input voltage, and a second switch SW20 as a synchronous rectification switch. The DC-DC converter 10 is configured to lower the voltage of the direct-current voltage input from an external direct-current voltage source BAT0 to an input terminal IN 10, and to output the lowered direct-current voltage to an external load RL0 which is connected to an output OUT 10. Moreover, the DC-DC converter 10 includes a first inductor L10 and a capacitor C10. The first switch SW10 and the second switch SW20 are FETs (Field Effect Transistors) which switch on and off the region between the source and the drain by using the voltage applied to the gate. For the first switch SW10 and the second switch SW20, a MOSFET (Metal-Oxide-Semiconductor Field-Effect Transistor) having a low ON-resistance is widely used. The MOSFET is known to form a parasitic diode (body diode) between the inner source and the drain.

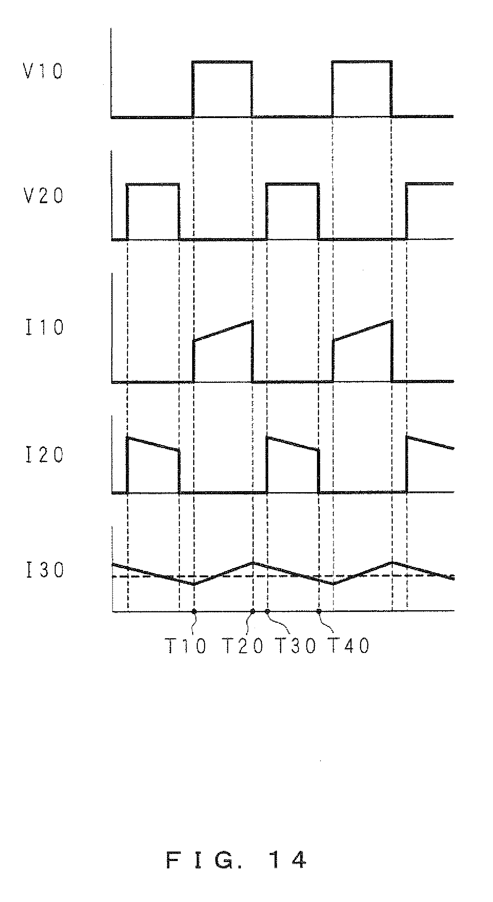

FIG. 14 is a timing chart illustrating the operation of the conventional DC-DC converter 10. The horizontal axis and vertical axis of the graphs indicate time and the value of a voltage or an electric current. The voltage V10 and the voltage V20 applied to the gate of each of the first switch SW10 and the second switch SW20 are controlled to become an ON-voltage in an alternating manner with the dead-time period during which both the voltage V10 and voltage V20 become an OFF-voltage. Accordingly, the first switch SW10 and the second switch SW20 are turned on in an alternating manner with the dead-time period. As the electric current I10 flows through the first switch SW10 that is turned on at a time point T10, the energy is accumulated at the first inductor L10, and the electric current I10 gradually increases over time.

At a time point T20, the first switch SM10 is turned off, and the electric current I10 instantly becomes zero. As the electric current I30 of the first inductor L10 tends to maintain the inertial force, the electric current I20 flows through the parasitic diode of the SW20. At the time point T20, the second switch SW20 is turned on, and due to the inertial force of the first inductor L10, the electric current I20 flows through the second switch SW20 and is gradually attenuated. At a time point T40, the second switch SW20 is turned off, and due to the inertial force of the first inductor L10, the electric current I20 flows through the parasitic diode of the SW20 during the dead-time period between the time point T30 and the time point T40, with the electric current I20 being gradually attenuated. The electric current I30 becomes the sum of the electric current I10 and the electric current I20, and becomes a direct current including a DC component and a ripple component that repeats a monotone increase and monotone decrease.

The electric current I30 is smoothed as its ripple component is removed by the capacitor C10, and is output to the load RL0 as a direct current whose voltage is lowered to a specified direct-current voltage. By changing the respective duty ratios of the voltage V10 and the voltage V20, the direct-current voltage to be output to the load RL0 is adjusted.

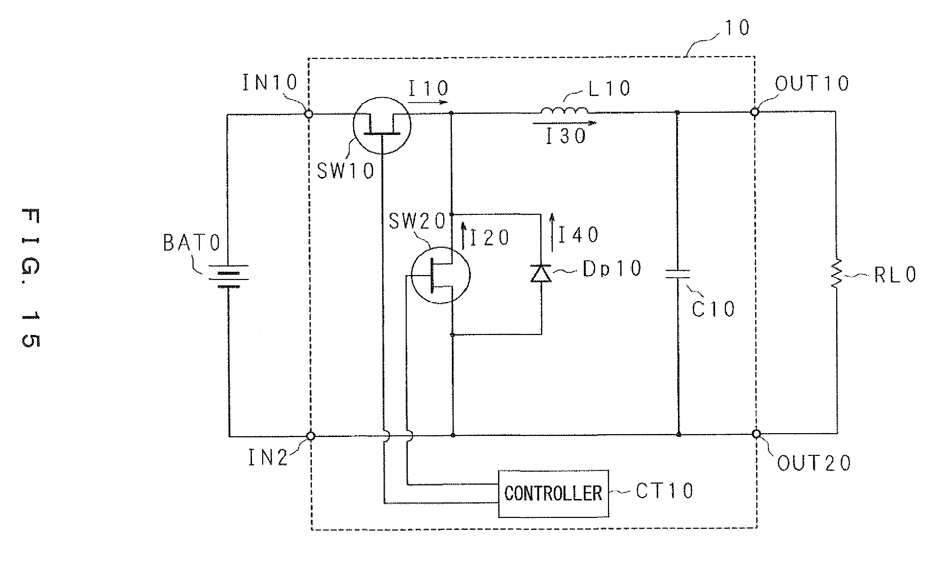

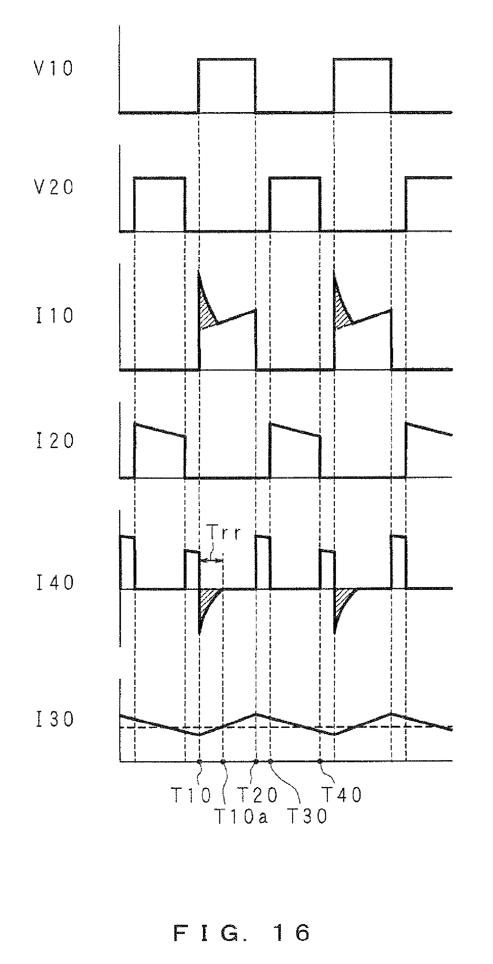

FIGs. 15 and 16 are a schematic equivalent circuit diagram of the conventional DC-DC converter 10 and a timing chart illustrating the operation of the conventional DC-DC converter 10. The horizontal axis and vertical axis of the graphs of FIG. 16 indicate time and the value of a voltage or electric current. Between the source and drain of the second switch SW20, a parasitic diode Dp10 formed inside an FET is equivalently connected in parallel. During the dead-time period, a forward potential is applied to the parasitic diode Dp10, and thereby an electric current I40 flows. The parasitic diode of the FET has characteristics of a silicon bonding diode, and an electric charge is accumulated at the bonded interface as a forward current flows. Because an electric charge is accumulated at the bonded interface, the capacitor component at the bonded portion is increased. When the first switch SW10 is turned on at the time point T30 and a reverse voltage is applied to the parasitic diode Dp10, an inrush current to charge the capacitor at the bonded portion of the Dp10 occurs, and the diode shorts out for a moment. The phenomenon of recovering from the shorted-out state is called recovery phenomenon, and the time required for recovery is called recovery time.

Due to the recovery phenomenon, the reverse inrush current of the parasitic diode indicated in the diagonally shaded areas, i.e., a recovery current, occurs to the electric current I40. The recovery current is gradually attenuated, and becomes zero at the point in time at which the reverse recovery time Trr of the parasitic diode Dp10 is passed. The recovery current flows into the parasitic diode Dp10 via the first switch SW10, and the recovery current indicated in the diagonally shaded areas occurs to the electric current I10. The loss due to the recovery current, i.e., the recovery loss, lowers the circuit efficiency of the DC-DC converter 10.

The recovery loss occurs every time the first switch SW10 and the second switch SW20 are switched. If the frequency of switching on and off is increased in order to reduce the ripple component of the direct current, the recovery loss increases and the circuit efficiency becomes even lower. Moreover, the dead-time period that is a factor of lowering the circuit efficiency is set in accordance with the switching speed of a MOSFET so as to prevent the first switch SW10 and the second switch SW20 from being turned on and shorting out at the same time. A MOSFET with a high switching speed has a short recovery time, and thus it is possible to reduce the recovery dead-time loss and the recovery loss; however, there is a problem in that the resistance loss tends to be large. For this reason, even if a low-resistant MOSFET is used, it is still necessary to develop a method for reducing the recovery loss.

To this end, DC-DC converters which include a resonant circuit, thereby setting the electric current flowing through the second switch SW20 to be zero immediately before the switching between ON and OFF to reduce the recovery loss, is known (for example, see Patent Document 1). Moreover, DC-DC converters which apply a reverse voltage so as to cancel the electric charge accumulated at a diode, thereby inhibiting the recovery phenomenon and reducing the recovery loss, are known (for example, see Patent Document 2). Furthermore, methods for inhibiting the recovery phenomenon by connecting a Schottky diode to a MOSFET in parallel and transferring the electric current flowing through the parasitic diode of the MOSFET are known (for example, see non-Patent Document 1).

Patent Document 1: Japanese Laid-open Patent Publication No. 2002-044937
Patent Document 2: Japanese Laid-open Patent Publication No. 2007-252055
Non-Patent Document 1: Nobuhiko Yamashita, two others, Conduction Power Loss in MOSFET Synchronous Rectifier with Paraliel-Connected Schottky Barrier Diode, IEEE Transactions on Power Electronics, U.S., IEEE, June, 1998, No. 13, p. 667

In a DC-DC converter according to Patent Document 1, there has been a problem in which when the frequency of switching on and off switches is changed, it is difficult to inhibit the recovery current as the timing of a resonant circuit is shifted and the electric current does not become zero at the time of switching. Moreover, in a DC-DC converter according to Patent Document 2, there has been a problem in which an additional power source is required to apply a reverse voltage to a diode. Furthermore, in a DC-DC converter according to Non-Patent Document 1, there has been a problem in which it is difficult to achieve an advantageous effect as the inductance connected to a Schottky diode in series prevents the electric current from being transferred.

Summary

The present application has been made in view of the above-mentioned circumstances. An object of the present application is to provide a DC-DC converter, a module, a power supply device, and an electronic apparatus which enable the recovery loss to be easily reduced by interposing a mutually connected second inductor and third switch in series between the intermediate connection part of the first and second switches and a grounding terminal.

A DC-DC converter disclosed in the present application is a DC-DC converter which lowers a direct-current voltage input to an input terminal, and which outputs the lowered direct-current voltage from an output terminal, the DC-DC converter including: a first switch and a second switch which are both connected to the input terminal and to a fixed-potential terminal in series; a first inductor interposed between an intermediate connection part of the first and second switches and the output terminal; a second inductor and a third switch which are both interposed between the intermediate connection part and the fixed-potential terminal, and which are connected to each other in series; and a capacitor to connect between the output terminal and the fixed-potential terminal.

According to an aspect of the device, it is possible to easily reduce the recovery loss by interposing the mutually connected second inductor and third switch in series between the intermediate connection part of the first and second switches and a fixed-potential terminal.

BRIEF DESCRIPTION OF DRAWINGS

FIG. 1 is a schematic circuit diagram illustrating an example of a DC-DC converter.
FIG. 2 is a schematic equivalent circuit diagram illustrating a DC-DC converter.
FIG. 3 is a timing chart illustrating the operation of a DC-DC converter.
FIG. 4 is a diagram illustrating a result of the simulation of a control voltage and a circuit current.
FIG. 5 is a timing chart illustrating the operation of a DC-DC converter.
FIG. 6 is a schematic diagram illustrating an example of a converter circuit board.
FIG. 7 is a schematic diagram illustrating an example of a converter circuit board.

FIG. 8 is a schematic diagram illustrating an example of a converter circuit board.

FIG. 9 is a schematic diagram illustrating an example of a converter circuit board.

FIG. 10 is a schematic diagram illustrating an example of a converter circuit board.

FIG. 11 is a schematic diagram illustrating an example of a converter circuit board.

FIG. 12 is a schematic diagram illustrating a server device which includes a power source unit.

FIG. 13 is a schematic circuit diagram illustrating a conventional DC-DC converter.

FIG. 14 is a timing chart illustrating the operation of a conventional DC-DC converter.

FIG. 15 is a schematic equivalent circuit diagram of a conventional DC-DC converter.

FIG. 16 is a timing chart illustrating the operation of a conventional DC-DC converter.

DESCRIPTION OF EMBODIMENTS

Embodiment 1

Some Embodiments will be described in a specific manner with reference to the accompanying drawings. A DC-DC converter according to the present embodiment is used as a switching power source or the like which converts a DC input voltage into a power source voltage when a power source voltage is supplied to an information device or the like. Switching power sources are used as power sources that supply an electronic apparatus such as a computer with a direct-current power source. Moreover, switching power sources are used as a variable power source that provides a voltage-adjusted power source for an illumination light, an audio device, a microwave oven, or the like. Switching power sources are also used as a power source that provides a drive power source for a motor integrated in a washing machine, a refrigerator, an air conditioner, or the like. Switching power sources are used as a power source that supplies not only a small amount of electricity but also a large amount of electricity to a drive motor of a vehicle, an electric train, or the like.

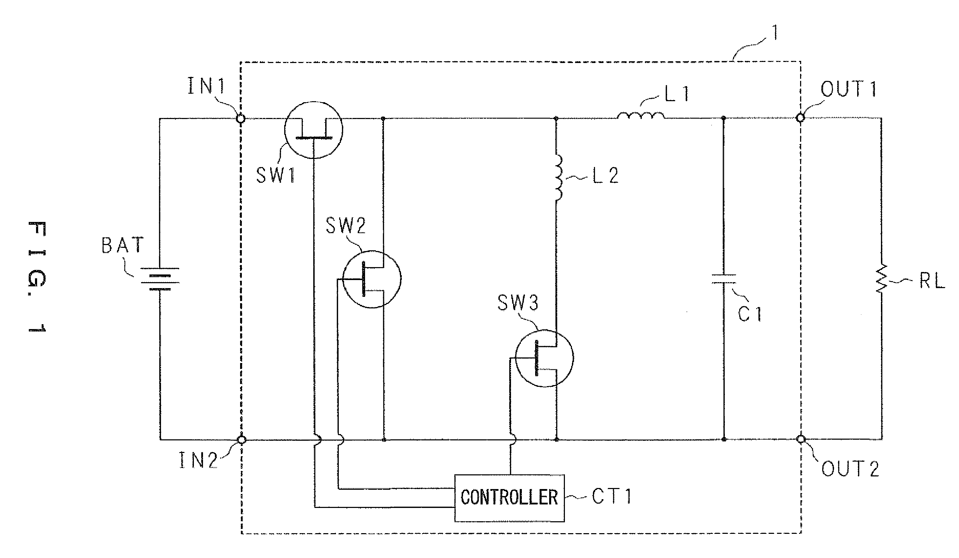

FIG. 1 is a schematic circuit diagram illustrating an example of a DC-DC converter. The reference sign "1" indicates a DC-DC converter, and the anode and cathode of an external direct-current power source BAT are connected to an input terminal IN1 and an input terminal (fixed-potential terminal) IN2, respectively. The DC-DC converter 1 lowers the DC input voltage given by the direct-current power source BAT to supply an external load RL connected to an output terminal OUT1 and an output terminal OUT2 with the lowered voltage as a power source.

The DC-DC converter 1 includes a first switch SW1, a second switch SW2, and a third switch SW3, and each switch is a MOSFET that is switched ON and OFF by the voltage applied to the gate. Moreover, the second switch SW2 and the third switch SW3 may be a semiconductor switch to which a diode is connected in parallel. In this case, the diode connected in parallel corresponds to a parasitic diode, which will be described later. Here, cases in which the second switch SW2 and the third switch SW3 are MOSFETs will be described as examples.

The source of the first switch SW1 is connected to the input terminal IN1. The source of the second switch SW2 is connected to the drain of the first switch SW1. The input terminal IN2 is connected to the drain of the second switch SW2. Accordingly, between the input terminal IN1 and the input terminal IN2, the first switch SW1 and the second switch SW2 are connected in series. The intermediate connection point of the first switch SW1 and the second switch SW2 is connected to the output terminal OUT1 through a first inductor L1. Moreover, the intermediate connection point of the first switch SW1 and the second switch SW2 is also connected to the source of the third switch SW3 through a second inductor L2.

The first inductor L1 is a smoothing filter for the switching voltage. A capacitor C1 is connected between the output terminal OUT1 and the output terminal OUT2. Moreover, the DC-DC converter 1 includes a controller CT1 for controlling the ON/OFF switching of the gates of the first switch SW1, the second switch SW2, and the third switch SW3 by applying a voltage thereto. The second inductor L2 is connected to the third switch in series.

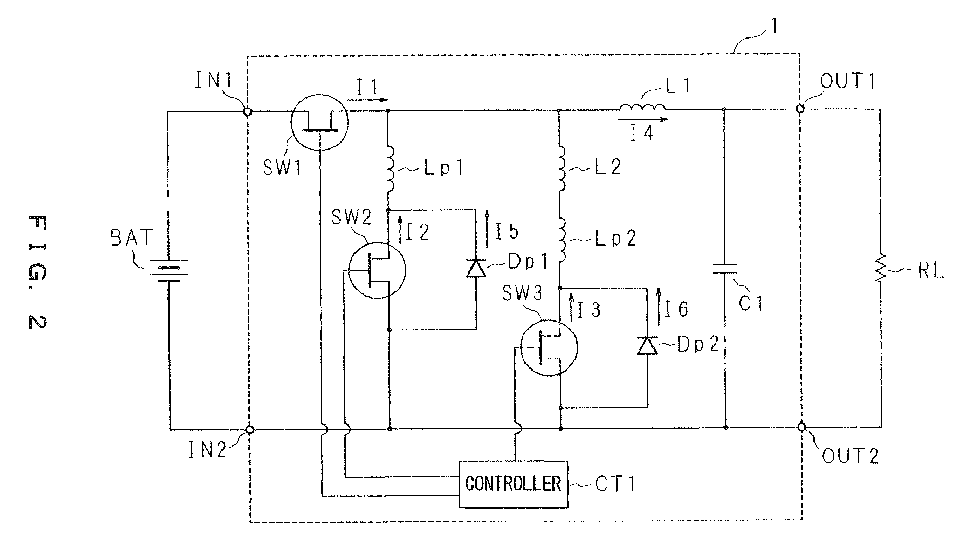

FIG. 2 is a schematic equivalent circuit diagram illustrating the DC-DC converter 1. FIG. 2 illustrates an equivalent circuit to the circuit of FIG. 1, further including a parasitic diode and an equivalent series-inductance. Between the source and drain of the second switch SW2, a parasitic diode Dp1 formed in a MOSFET is equivalently connected in parallel. Moreover, a parasitic inductor Lp1 having the equivalent series-inductance, which is caused by the package of the MOSFET, the wiring in the MOSFET, or the like, is equivalently connected to the source of the second switch SW2 in parallel.

In a similar manner, a parasitic diode Dp2 is equivalently connected between the source and drain of the third switch SW3 in parallel, and a parasitic inductor Lp2 is equivalently connected to the source of the third switch SW3 in parallel. The inductance of the second inductor L2 is selected so as to fulfill the following equation.

$$L2 + Lp2 > Lp1 \qquad (1)$$

Here, the inductance of the second inductor L2 may be selected so as to be larger than the inductance of the parasitic inductor Lp1 of the second switch SW2, thereby fulfilling equation (1).

It is assumed that the electric currents flowing on the output sides of the first switch SW1, the second switch SW2, and the third switch SW3 are I1, I2, and I3, respectively.

Moreover, it is assumed that the voltages applied to the gates of the first switch SW1, the second switch SW2, and the third switch SW3 are V1, V2, and V3, respectively. It is assumed that the electric currents flowing through the first inductor L1, the parasitic diode Dp1, and the parasitic diode Dp2 are I4, I5, and I6. Next, the operation of the DC-DC converter 1 will be described.

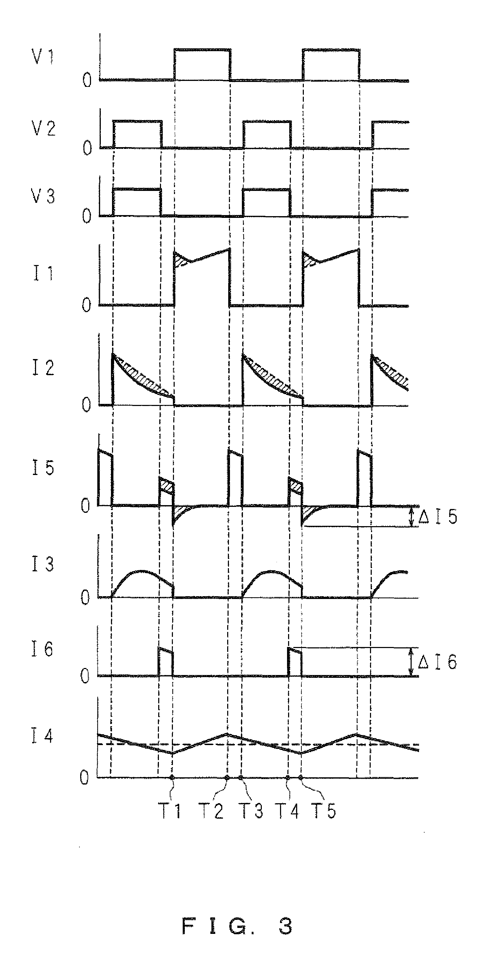

FIG. 3 is a timing chart illustrating the operation of the DC-DC converter 1. FIG. 3 lists the voltage V1, voltage V2, and voltage V3, and the electric current I1, electric current I2, electric current I5, electric current I3, electric current I6, and electric current I4 from the uppermost row to the lowermost row. The horizontal axis and vertical axis of the graphs indicate time and the value of a voltage or an electric current. The controller CT1 controls the voltage V1 and voltage V2 so as to become an ON-voltage in an alternating manner with the dead-time period during which both the voltage V1 and voltage V2 become an OFF-voltage. Moreover, the controller CT1 controls the voltage V3 so as to become an ON-voltage in synchronization with the voltage V2. Accordingly, the first switch SW1 and the second and third switches SW2 and SW3 are turned on in an alternate manner with the dead-time period.

The electric current I1 flows through the first switch SW1 at a time point T1 at which the first switch SW1 is turned on, and the electric current I1 gradually increases over time as the energy is accumulated at the first inductor L1. Moreover, in the electric current T1, a recovery current, as will be described later, appears as indicated in the diagonally shaded areas. At a time point T2, the first switch SW1 is turned off, and the electric current I1 instantly becomes zero. As the electric current I4 of the first inductor L1 tends to maintain the inertial force, the electric current I5 flows through the parasitic diode Dp1 of the second switch SW2. As the second inductor L2 connected to the parasitic diode Dp2 in series through the parasitic diode Dp2 blocks an electric current, almost none of the electric current I3 flows through the parasitic diode Dp2.

At a time point T3, the second switch SW2 and the third switch SW3 are synchronously turned on. Accordingly, the electric current I5 flowing through the parasitic diode Dp1 between the time points T2 and T3 flows into the second switch SW2 and the third switch SW3. A part of the electric current I5 instantly flows into the second switch SW2 as the electric current I2. On the other hand, a part of the electric current I5 gradually flows into the third switch SW3 as an electric current is blocked by the second inductor L2 which is connected to the third switch SW3 in series through the parasitic inductor Lp2. By the inertial force which is caused at the first inductor L1 as the second switch SW2 and the third switch SW3 are turned off at a time point T4, the electric current I2 flows with gradual attenuation during the dead-time period.

A portion of both the electric current I2 and electric current I3 flowing during the dead-time period flows into the parasitic diodes Dp1 and Dp2 as the electric current I5 and I6. At a time point T5, the first switch SW1 is turned on again, and a reverse potential is applied to both of the parasitic diodes Dp1 and Dp2. A recovery phenomenon occurs to the parasitic diode Dp1 due to the electric charge accumulated by the electric current I5 that flew during the dead-time period, and due to the reverse potential applied by the first inductor L1. As a result, the recovery current indicated in the diagonally shaded areas flows into the electric current I5.

In a similar manner, a recovery phenomenon occurs to the parasitic diode Dp2 due to the electric current I6 which flowed during the dead-time period, and due to the reverse potential applied by the first inductor L1. The parasitic inductor Lp2 connected to the parasitic diode Dp2 in series has a larger inductance than that of the parasitic inductor Lp1 which is connected to the parasitic diode Dp1 in series. Accordingly, the recovery current that occurred due to the recovery phenomenon caused at the parasitic diode Dp2 is blocked by the parasitic inductor Lp2 and thus does not flow into the electric current I6.

The recovery current flows into the electric current I5 via the first switch SW1, and thus the recovery current of the electric current I1. indicated in the diagonally shaded areas flows into the electric current I5. The electric current I4 is the sum of the electric current I1, the electric current I2, and an electric current I3, and is a direct current including a DC component and a ripple component that repeats a monotone increase and a monotone decrease. The electric current I4 is smoothed as the capacitor C1 removes a ripple component, and is output to a load RL as the direct current whose voltage is lowered to a specified direct-current voltage. As the duty ratio of the voltage V1 to the voltage V2 and voltage V3 is varied, the direct-current voltage output to the load RL is adjusted.

The electric current I5 which was flowing through the parasitic diode Dp1 during the dead-time period between the time point T2 and the time point T3 is branched into the electric current I2 and the electric current I3 when the second switch SW2 and the third switch SW3 are turned on. The electric current I2 instantly flows into the second switch SW2, and the electric current I3 gradually flows into the third switch SW3 as an electric current is blocked by the second inductor L2. As a result, the electric current I2 flowing through the second switch SW2 is reduced by the amount indicated in the diagonally shaded areas of FIG. 3 due to the provided third switch SW3. Furthermore, as the electric current I2 is reduced, the electric current I5 that flows during the dead-time period is reduced, and the electric charge accumulated at the parasitic diode Dp1 is reduced.

When the first switch SW1 is turned on as the accumulated electric charge is reduced, the recovery electric current caused by the parasitic diode Dp1 becomes smaller compared with the case of the conventional DC-DC converter which does not include the second inductor L2 and the third switch SW3. In the example of FIG. 3, a peak value $\Delta I5$ of the recovery current indicated in the diagonally shaded areas of the electric current I5 becomes smaller due to the provided third switch SW3. As the recovery current is reduced, the recovery loss of the DC-DC converter 1 becomes smaller compared with the case of the conventional DC-DC converter.

As the recovery current flowing through the parasitic diode Dp2 is blocked by the second inductor L2, the recovery current does not cause a large loss by flowing in the circuit. The loss due to the electric charge sent to the parasitic diode Dp2 in the recovery phenomenon still occurs. A MOSFET having a shorter reverse recovery time Trr compared with a reverse recovery time for the second switch SW2 is selected for the third switch SW3, and thus the recovery phenomenon is reduced, and the loss due to the sent electric charge is also reduced. Generally, a MOSFET having a short reverse recovery time Trr has a high ON-resistance, and a MOSFET having a long reverse recovery time Trr has a low ON-resistance. Accordingly, the third switch SW3 has a higher ON-resistance than that of the second switch SW2. The electric current I6 flowing into the third switch SW3 is smaller and flows for shorter period of time than the electric current I3 that flows into the third switch SW2, and thus the electric current I6 flowing through the high ON-resistance of the third switch SW3 does not cause a large loss.

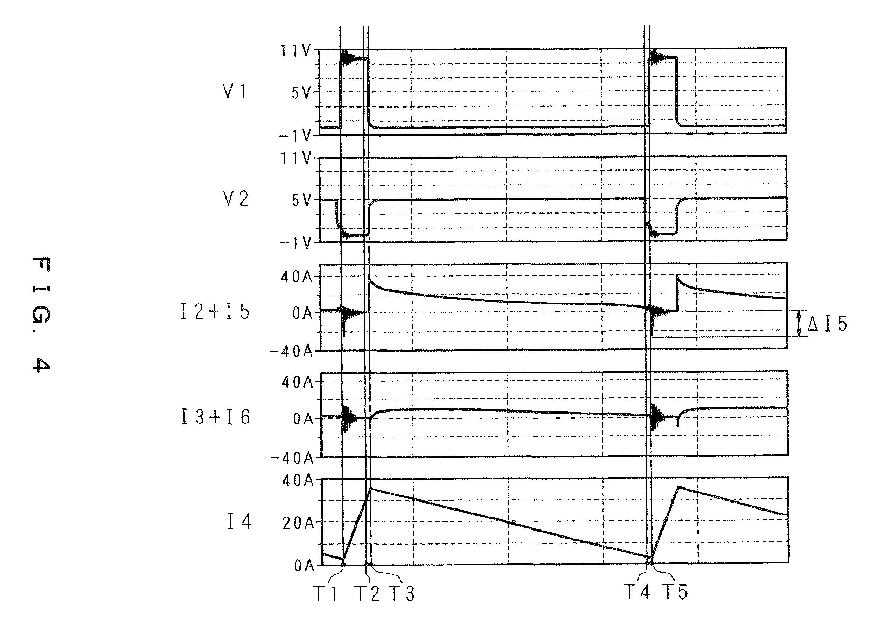

FIG. 4 is a diagram illustrating a result of the simulation of a control voltage and a circuit current. FIG. 4 illustrates a result of the simulation of the control voltage and circuit current when the first inductor L1, the second inductor L2, and the inductance of the parasitic inductor Lp1 are 100nH, 2nH, and 0.5nH, respectively. Moreover, it is defined that the time points T2, T3, T4, and T5 represent the time elapsed since the time point T1 by 300nsec, 320nsec, 3010msec, and 3333nsec, respectively. It is also defined that the input voltage input to the input terminal IN1 and the output voltage output from the output terminal OUT1 are 12V and 1V, respectively, with a switching frequency of 300kHz.

FIG. 4 lists the voltage V1 and the voltage V2 as a control voltage, the sum of the electric current I2 and electric current I5 as a circuit current, the sum of the electric current I3 and electric current I6 as a circuit current, and the electric current I4 as a circuit current from the uppermost row to the lowermost row. $\Delta I5$ in FIG. 4 indicates a peak value of the recovery current flowing through the parasitic diode Dp1. $\Delta I5$ indicates 26A, which is smaller than the 33A obtained in the simulation result of the conventional synchronously-rectifying DC-DC converter which does not include the second inductor L2 and the third switch SW3. Moreover, the circuit efficiency is 83%, which is higher than the 77% of the conventional synchronously-rectifying DC-DC converter when the output current is 20A.

Embodiment 2

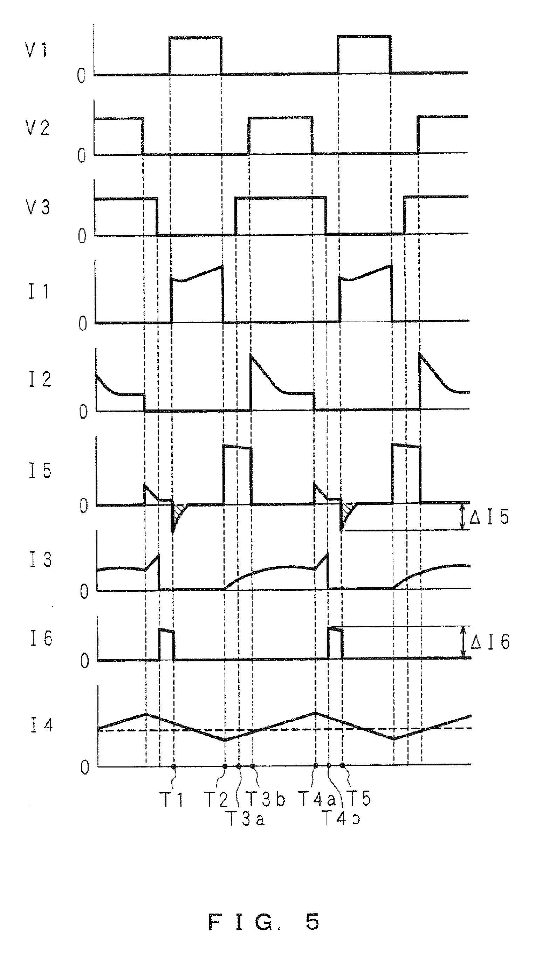

FIG. 5 is a timing chart illustrating the operation of the DC-DC converter 1. The horizontal axis and vertical axis of the graphs indicate time and the value of a voltage or an electric current. While the second switch SW2 and the third switch SW3 are turned on approximately at the same time in the Embodiment 1, the second switch SW2 and the third switch SW3 are turned on with a specified time lag in the present Embodiment 2. The controller CT1 switches on the third switch SW3 after the first switch SW1 is turned on and before the second switch SW2 is turned on. Moreover, the controller CT1 switches off the third switch SW3 after the second switch SW2 is turned off and before the first switch SW1 is turned on.

The electric current I1 flows through the first switch SW1 at the time point T1 at which the first switch is turned on, and the electric current I1 gradually increases over time as the energy is accumulated at the first inductor L1. At the time point T2, the first switch SW1 is turned off, and the electric current I1 instantly becomes zero. As the electric current I4 of the first inductor L1 tends to maintain the inertial force, the electric current I5 flows through the parasitic diode Dp1 of the second switch SW2. At the time point T3a, the third switch SW3 is turned on, and the electric current I5 which was flowing through the parasitic diode Dp1 gradually flows into the third switch SW3 as the electric current I3 via the second inductor L2. At the time point T3b, the second switch SW2 is turned on, and the electric current I5 which was flowing through the parasitic diode Dp1 instantly flows into the second switch SW2 as the electric current I2, and is gradually attenuated.

If the second switch SW2 is turned off at the time point T4a, the electric current I2 which was flowing through the second switch SW2 flows into the third switch SW3 in the ON-state, and the electric current I3 increases. At the time point T4b, the third switch SW3 is turned off, and the electric current I5 and the electric current I3 continues to flow due to the inertial force of the second inductor L2, and is gradually attenuated. Moreover, the electric current I3 flows into the parasitic diode Dp2, and flows as the electric current I6. At the time point T5, the first switch SW1 is turned on again, and a reverse potential is applied to both parasitic diodes Dp1 and Dp2. At the parasitic diode Dp1, a recovery phenomenon occurs due to the electric charge accumulated by the electric current I5 which flowed between the time point T4a and the time point T5, and due to the applied reverse potential.

Then, the recovery current indicated in the diagonally shaded areas flows into the electric current I5. In a similar manner, a recovery phenomenon also occurs to the parasitic diode Dp2, but the recovery current does not flow into the electric current I6 as blocked by the second inductor L2. As the third switch SW3 is turned off later than the second switch SW2, the dead-time period between the time point T4b and the time point T5 becomes shorter, and the electric charge accumulated at the parasitic diode Dp1 becomes smaller than that in the Embodiment 1. Accordingly, the recovery phenomenon occurring to the parasitic diode Dp1 at the time point T5 is inhibited, and thus the recovery current is reduced. As a result, the recovery loss is further reduced.

A simulation is performed with the first inductor L1, the second inductor L2, and the inductance of the parasitic inductance Lp1 being 100nH, 2nH, and 0.5nH. Moreover, it is defined that the time points T2, T3a, and T3b represent the time elapsed since the time point T1 by 300nsec, 305nsec, and 320nsec, respectively. Furthermore, it is defined that the time points T4a, T4b, and T5 represent the time elapsed since the time point T1 by 3010msec, 3333nsec, and 3290nsec, respectively. It is also defined that the input voltage and the output voltage are 12V and 1V, respectively, with a switching frequency of 300kHz. ΔI5 indicates 11A which is even smaller than the 26A obtained in the simulation result obtained in the Embodiment 1. Moreover, the circuit efficiency is 83%, which is even higher than the 80% of the Embodiment 1 when the output current is 20A.

The present Embodiment 2 has been described above, and regarding the other points, Embodiment 2 is similar to Embodiment 1. For this reason, the same reference signs are given to the corresponding elements, and detailed descriptions are omitted.

Embodiment 3

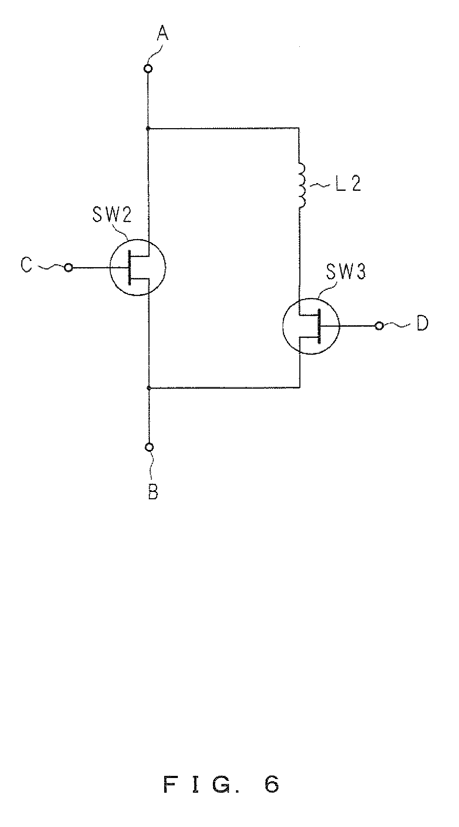

FIG. 6 is a schematic circuit diagram illustrating a module. In the present Embodiment 3, a portion of the circuit of Embodiment 1 is modularized. A module includes the second switch SW2, the third switch SW3, and the second inductor L2. The source of the second switch SW2 is connected to a terminal A, and to the source of the third switch SW3 through the second inductor L2. The drains of the second switch SW2 and the third switch SW3 are connected to a terminal B. The gates of the second switch SW2 and the third switch SW3 are connected to a terminal C and a terminal D, respectively. If the second switch of the conventional synchronously rectifying DC-DC converter is replaced by using a module, it becomes possible to manufacture the DC-DC converter 1. Moreover, if the second switch of the conventional synchronously rectifying DC-DC converter is replaced with a module, it becomes possible to change the conventional synchronously rectifying DC-DC converter to the DC-DC converter 1 of the Embodiments 1 and 2.

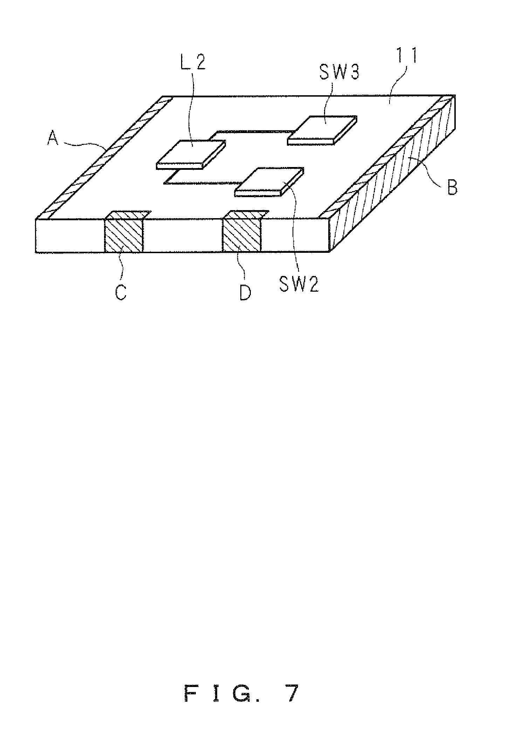

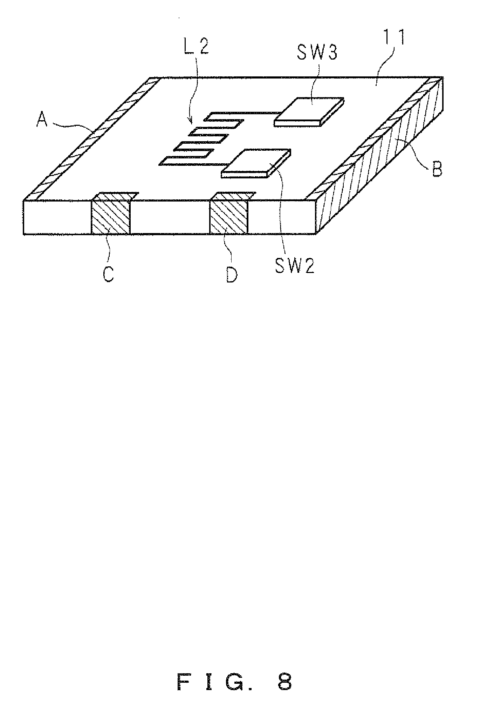

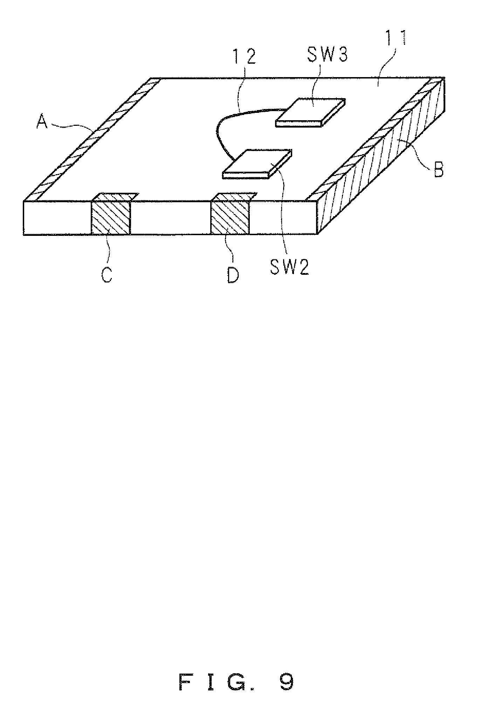

FIGs. 7, 8, and 9 are schematic diagrams illustrating an example of a module. In the module, the second switch SW2, the third switch SW3, and the second inductor L2 as well as terminals A, B, C, and D are implemented on the substrate or the sides of the dielectric. The second inductor L2 is, for example, a chip inductor that is implemented on the substrate. In the example of FIG. 8, the second inductor L2 is formed by the wiring patterned on the substrate. In the example of FIG. 9, the second inductor L2 is formed by a lead wire which is wired between the second switch SW2 and the third switch SW3 by using wire bonding.

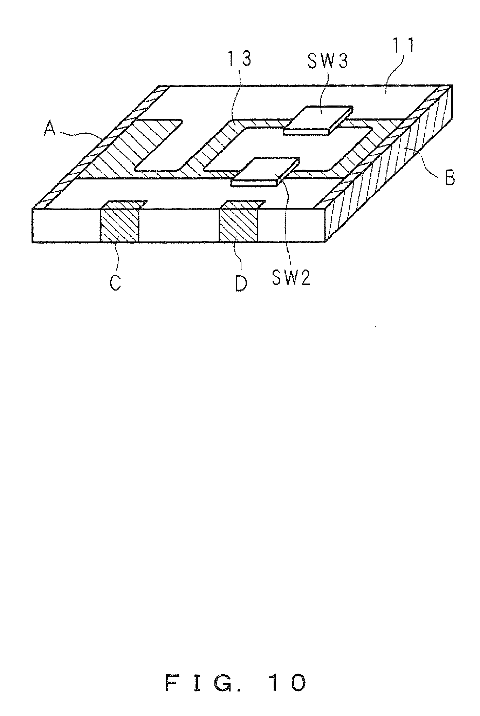

FIG. 10 is a schematic diagram illustrating an example of a module. In the example of FIG. 10, second switch SW2 and the third switch SW3 are each connected to the terminals A and B by using a metallic plate. The length of wiring between the third switch SW3 and the terminal A is longer than the length of wiring between the second switch SW2 and the terminal A. For this reason, the parasitic inductance between the third switch SW3 and the terminal A becomes larger than the parasitic inductance between the second switch SW2 and the terminal A. In other words, the parasitic inductance caused by the metallic plate between the third switch SW3 and the terminal A functions as the second inductor L2, which has a larger inductance than the parasitic inductance of the second switch SW2.

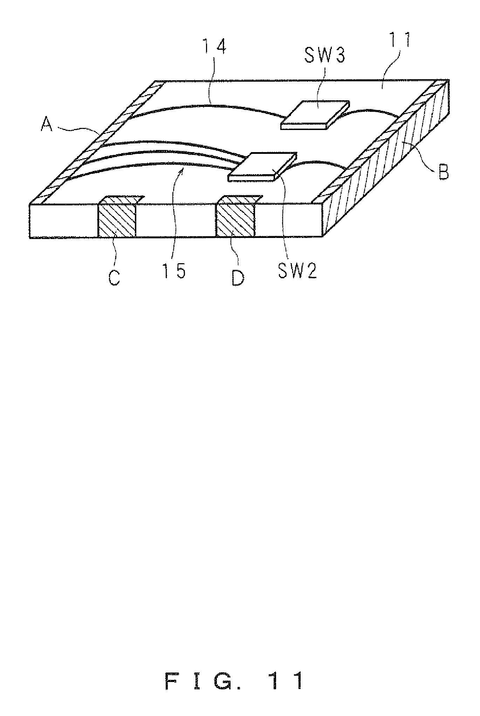

FIG. 11 is a schematic diagram illustrating an example of a module. In the example of FIG. 11, the second switch SW2 and the third switch SW3 are each wired to the terminals A and B with lead wires by using wire bonding. The number of wirings between the third switch SW3 and the terminal A is fewer than the number of wirings between the second switch SW2 and the terminal A. For this reason, the parasitic inductance between the third switch SW3 and the terminal A becomes larger than the parasitic inductance between the second switch SW2 and the terminal A. In other words, the parasitic inductance caused by the lead wire between the third switch SW3 and the terminal A functions as the second inductor L2 which has a larger inductance than the parasitic inductance of the second switch SW2. Alternatively, the module may be a monolithic IC in which a single silicon substrate is used as a dielectric substrate, and the second inductor L2, the second switch SW2, and the third switch SW3 are integrated on the silicon substrate.

The present Embodiment 3 has been describe above, and regarding the other points, Embodiment 3 is similar to Embodiments 1 and 2. For this reason, the same reference signs are given to the corresponding elements, and the detailed descriptions are omitted.

Embodiment 4

In the present Embodiment 4, a power supply device including the DC-DC converter 1 described with respect to the Embodiments 1 and 2, and an electronic apparatus including the power supply device will be described. The power supply device is configured to rectify the alternating voltage obtained from an AC power supply such as a commercial power source into a direct-current voltage, and to lower the rectified voltage to a specified direct-current voltage to be supplied to a target apparatus as a power source. The power supply device is not limited to an independent use, and when it is integrated into an electronic apparatus such as a personal computer or a server device (computer) as a power source unit, the power supply device supplies the electronic apparatus with a power source. Here, the case in which the electronic apparatus is a server device will be described as an example.

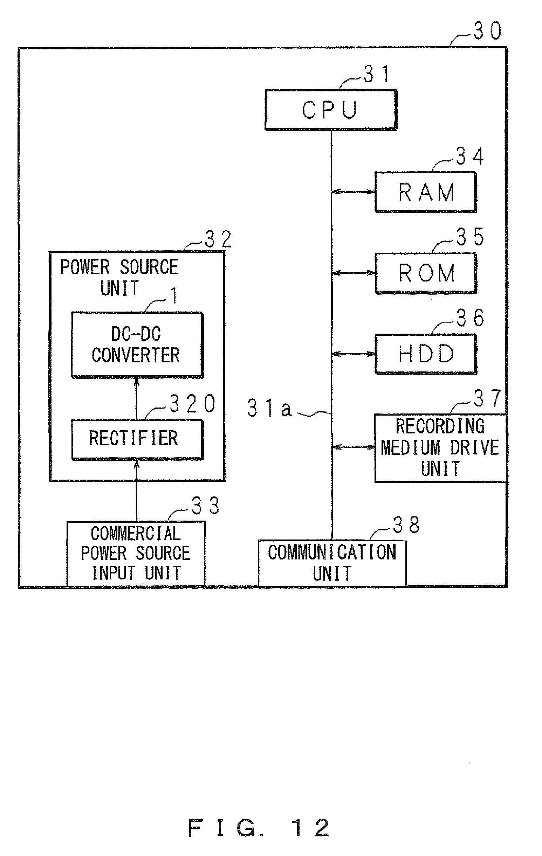

FIG. 12 is a block diagram illustrating a server device which includes a power source unit. A server device 30 includes a CPU 31, a recording medium drive 37 which reads a program or the like recorded on a recording medium, an HDD 36 which stores the read program or the like, and a ROM 35 in which various types of data is stored. The CPU 31 is configured to read out the program stored in the HDD 36 to a RAM 34, and to execute the read program. The CPU 31 controls the hardware parts via a bus 31a, and communicate with an external device via the external network connected to a communication unit 38.

Moreover, the server device 30 includes a commercial power source input unit 33 to which an alternating voltage of 100V and 200V or the like is input from an external commercial alternating-current power supply, and a power source unit 32 which converts the alternating voltage into a direct-current voltage to lower the voltage, and which supplies hardware parts with a power source. The power source unit 32 includes a rectifier 320 which rectifies the commercial alternating-current power supply to convert it into a direct-current voltage, and the DC-DC converter 1 which lowers the direct-current voltage to supply the hardware parts with the lowered voltage. As the server device 30 includes the DC-DC converter 1 in which the recovery loss is reduced, the power consumption is reduced.

The present Embodiment 4 has been describe above, and regarding the other points, Embodiment 4 is similar to Embodiments 1 to 3. For this reason, the same reference signs are given to the corresponding elements, and the detailed descriptions are omitted.

**Claims**

1. A DC-DC converter which lowers a direct-current voltage input to an input terminal, and which outputs the lowered direct-current voltage from an output terminal, the DC-DC converter comprising:

   a first switch and a second switch which are both connected to the input terminal and to a fixed-potential terminal in series;
   a first inductor interposed between an intermediate connection part of the first and second switches and the output terminal;
   a second inductor and a third switch which are both interposed between the intermediate connection part and the fixed-potential terminal, and which are connected to each other in series; and
   a capacitor to connect between the output terminal and the fixed-potential terminal.

2. The DC-DC converter according to claim 1, further comprising
   a controller to turn on the first switch and the second and third switches in an alternating manner, and to turn on and off the second switch and the third switch in a synchronous manner.

3. The DC-DC converter according to claim 1, further comprising
   a controller to turn on the first switch and the second and third switches in an alternating manner, to turn on the second switch after a specified period of time has elapsed since a time point at which the third switch is turned on, and to turn off the third switch after a specified period of time has elapsed since a time point at which the second switch is turned off.

4. The DC-DC converter according to any one of claims 1 to 3, wherein
   the second inductor has a larger inductance than an equivalent series-inductance of the second switch.

5. The DC-DC converter according to any one of claims 1 to 4, wherein
   the second switch and the third switch are each a MOSFET having a parasitic diode between a source and a drain.

6. The DC-DC converter according to any one of claims 1 to 5, wherein
   the second switch and the third switch are each a semiconductor switching element to which a diode is connected in anti-parallel fashion.

7. The DC-DC converter according to any one of claims 1 to 6, wherein
   the third switch has a smaller reverse recovery time than a reverse recovery time of the second switch.

8. A module having a first switch connected to an input terminal, a first inductor interposed between the first switch and an output terminal, and a capacitor to connect between the output terminal and a fixed-potential terminal, the module being used for a DC-DC converter which lowers a direct-current voltage input to the input terminal, and which outputs the lowered direct-current voltage from the output terminal, the module comprising:

   a dielectric substrate;
   a second switch and a third switch which are both disposed on the dielectric substrate, and which are both connected between the first switch and the fixed-potential terminal in parallel; and
   a first inductor which is disposed on the dielectric substrate, and which is interposed between an intermediate connection part of the first and second switches and the output terminal.

9. The module according to claim 8, wherein the second inductor is formed by a conductor line.

10. The module according to claim 8, wherein the second inductor is formed by a conductor plate.

11. A power supply device including the DC-DC converter according to any one of claims 1 to 10.

12. An electronic apparatus including the power supply device according to claim 11

F I G.　1

F I G.  2

V 1

V 2

V 3

I 1

I 2

I 5

$\Delta$ I 5

I 3

I 6

$\Delta$ I 6

I 4

T 1  T 2  T 3  T 4  T 5

F I G.  3

F I G. 4

F I G. 5

F I G. 6

FIG. 7

F I G.　8

F I G. 9

F I G. 1 0

F I G.  1 1

FIG. 12

F I G. 1 3

F I G. 1 4

F I G .  1 5

F I G .  1 6

## INTERNATIONAL SEARCH REPORT

| | International application No. |
|---|---|
| | PCT/JP2009/061899 |

A. CLASSIFICATION OF SUBJECT MATTER
*H02M3/155(2006.01)i, H01L25/07(2006.01)i, H01L25/18(2006.01)i*

According to International Patent Classification (IPC) or to both national classification and IPC

B. FIELDS SEARCHED

Minimum documentation searched (classification system followed by classification symbols)
H02M3/155, H01L25/07, H01L25/18

Documentation searched other than minimum documentation to the extent that such documents are included in the fields searched
Jitsuyo Shinan Koho       1922-1996   Jitsuyo Shinan Toroku Koho   1996-2009
Kokai Jitsuyo Shinan Koho  1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2007-244156 A  (Fuji Electric Device Technology Co., Ltd.),<br>20 September, 2007 (20.09.07),<br>Par. Nos. [0016] to [0039]; Figs. 1 to 6<br>(Family: none) | 1,2,11,12<br>3-10 |
| Y<br>A | JP 2006-345628 A  (Toshiba Corp.),<br>21 December, 2006 (21.12.06),<br>Par. No. [0004]<br>& US 2006/0279965 A1 | 1,2,11,12<br>3-10 |
| A | JP 2008-72872 A  (Fuji Electric Device Technology Co., Ltd.),<br>27 March, 2008 (27.03.08),<br>Full text; all drawings<br>& US 2008/0067988 A1    & KR 10-2008-0025298 A | 1 |

☒  Further documents are listed in the continuation of Box C.          ☐  See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 31 July, 2009 (31.07.09) | 11 August, 2009 (11.08.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2009/061899 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2002-44937 A  (Sanyo Electric Co., Ltd.), 08 February, 2002 (08.02.02), Full text; all drawings (Family: none) | 1 |
| A | JP 2008-160951 A  (Ricoh Co., Ltd.), 10 July, 2008 (10.07.08), Full text; all drawings (Family: none) | 1 |
| A | JP 59-195857 A  (Fuji Denki Seizo Kabushiki Kaisha), 07 November, 1984 (07.11.84), Full text; all drawings (Family: none) | 1 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002044937 A

- JP 2007252055 A

**Non-patent literature cited in the description**

- **Nobuhiko Yamashita.** Conduction Power Loss in MOSFET Synchronous Rectifier with Paraliel-Connected Schottky Barrier Diode. *IEEE Transactions on Power Electronics,* June 1998, 667